# EUROPEAN PATENT APPLICATION

(11) **EP 4 716 440 A1**
(43) Date of publication of application: **25.03.2026**
(21) Application number: 23937482.0
(22) Date of filing: 16.05.2023
(51) Int. Cl.: H10N 60/12, H10N 60/01, H10N 60/80

(54) **LAMINATED STRUCTURE, QUANTUM DEVICE, AND METHOD FOR PRODUCING LAMINATED STRUCTURE**

(71) Applicant: FUJITSU LIMITED, Kawasaki-shi, Kanagawa 211-8588 (JP)
(72) Inventor: IWAI, Toshiki, Kawasaki-shi, Kanagawa 211-8588 (JP)
(74) Representative: Haseltine Lake Kempner LLP
(86) International application number: PCT/JP2023/018314
(87) International publication number: WO 2024/236740

(57) **Abstract**

A laminated structure includes a cooling member; a circuit board provided on the cooling member and formed with a through hole; a device provided on the circuit board and including a quantum bit; and a bonding material configured to bond the circuit board and the device to each other, wherein the bonding material includes a first bonding portion in contact with a portion of an upper surface of the cooling member exposed from the through hole, an upper surface of the circuit board, and a lower surface of the device; and a second bonding portion provided around the first bonding portion in plan view and in contact with at least the upper surface of the circuit board and the lower surface of the device, and wherein a thermal conductivity of the first bonding portion is higher than a thermal conductivity of the second bonding portion, and an elastic modulus of the second bonding portion is lower than an elastic modulus of the first bonding portion. The laminated structure can be used for quantum computing, for example.

## Description

### TECHNICAL FIELD

The present disclosure relates to a laminated structure, a quantum device, and a method of manufacturing the laminated structure.

### BACKGROUND ART

In recent years, quantum computers using qubits have been researched and developed. For example, a qubit substrate including qubits is provided on a die provided on a printed circuit board. The die is bonded to the printed circuit board by a bonding material. Because the qubit operates at a very low temperature of around -270 °C, not only the qubit but also a laminated structure including the die, the bonding material, and the printed circuit board are cooled.

### CITATION LIST

### PATENT DOCUMENT

Patent Document 1: Japanese Laid-open Patent Publication No. 2013-38375
Patent Document 2: Japanese Examined Patent Publication No. 61-42431
Patent Document 3: U.S. Patent No. 6190941
Patent Document 4: Japanese Laid-open Patent Publication No. 2007-81064
Patent Document 5: U.S. Patent Application Publication No. 2002/0079573

### SUMMARY OF INVENTION

### TECHNICAL PROBLEM

In order to maintain the temperature of the qubit at a very low temperature, it is desired that heat generated in a device (hereinafter, also referred to as "die") including the qubit is discharged with high efficiency. When a metal material such as silver is used as a bonding material, it is considered that heat generated in the die is transmitted to a circuit board, for example, a printed circuit board, with high efficiency. However, in this case, the difference between the coefficients of thermal expansion of the bonding material and the die and the coefficient of thermal expansion of the printed circuit board is large, and a large thermal stress caused by a temperature change tends to act on the die. When the thermal stress acts on the die, the characteristics of a circuit inside the die may change or the die may crack. In order to reduce the thermal stress, it is considered that a resin such as epoxy is used as a bonding material. However, in this case, it is difficult for the heat generated in the die to be transmitted to the printed circuit board, and the temperature of the qubit is difficult to be maintained at a very low temperature. As described above, in the conventional laminated structure, improvement of the thermal conductivity and mitigation of the thermal stress cannot be achieved simultaneously.

An object of the present disclosure is to provide a laminated structure, a quantum device, and a method of manufacturing the laminated structure, which can achieve both improvement of thermal conductivity and mitigation of thermal stress.

### SOLUTION TO PROBLEM

According to one aspect of the present disclosure, there is provided a laminated structure including a cooling member; a circuit board provided on the cooling member and formed with a through hole; a device provided on the circuit board and including a quantum bit; and a bonding material configured to bond the circuit board and the device to each other, wherein the bonding material includes a first bonding portion in contact with a portion of an upper surface of the cooling member exposed from the through hole, an upper surface of the circuit board, and a lower surface of the device; and a second bonding portion provided around the first bonding portion in plan view and in contact with at least the upper surface of the circuit board and the lower surface of the device, and wherein a thermal conductivity of the first bonding portion is higher than a thermal conductivity of the second bonding portion, and an elastic modulus of the second bonding portion is lower than an elastic modulus of the first bonding portion.

### ADVANTAGEOUS EFFECTS OF INVENTION

According to the present disclosure, both improvement of thermal conductivity and mitigation of thermal stress can be achieved.

### BRIEF DESCRIPTION OF THE DRAWINGS

[FIG. 1] FIG. 1 is a plan view illustrating a laminated structure according to a first embodiment.
[FIG. 2] FIG. 2 is a cross-sectional view illustrating a laminated structure according to a first embodiment.
[FIG. 3] FIG. 3 is a cross-sectional view (part 1) illustrating a method of manufacturing a laminated structure according to a first embodiment.
[FIG. 4] FIG. 4 is a cross-sectional view (part 2) illustrating a method of manufacturing a laminated structure according to a first embodiment.
[FIG. 5] FIG. 5 is a cross-sectional view (part 3) illustrating a method of manufacturing a laminated structure according to a first embodiment.
[FIG. 6] FIG. 6 is a cross-sectional view (part 4) illustrating a method of manufacturing a laminated structure according to a first embodiment.
[FIG. 7] FIG. 7 is a cross-sectional view (part 5) illustrating a method of manufacturing a laminated structure according to a first embodiment.
[FIG. 8] FIG. 8 is a cross-sectional view (part 6) illustrating a method of manufacturing a laminated structure according to a first embodiment.
[FIG. 9] FIG. 9 is a cross-sectional view illustrating a quantum device according to a second embodiment.

### DESCRIPTION OF EMBODIMENTS

Embodiments of the present disclosure will be specifically described below with reference to the accompanying drawings. In this specification and the drawings, components having substantially the same functional configuration are denoted by the same reference numerals, thereby omitting redundant descriptions.

### (First embodiment)

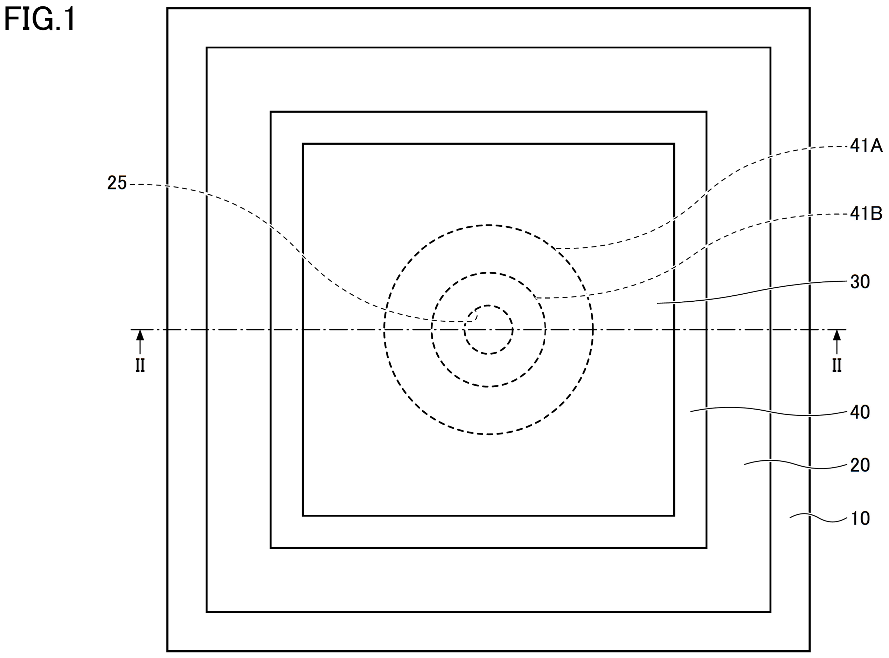

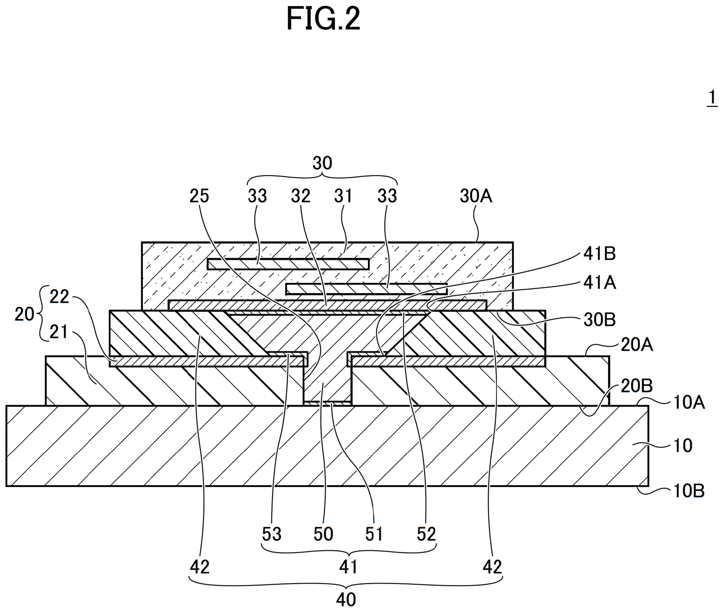

A first embodiment will be described. The first embodiment relates to a laminated structure used in a quantum computer. FIG. 1 is a plan view illustrating a laminated structure according to the first embodiment. FIG. 2 is a cross-sectional view illustrating a laminated structure according to the first embodiment. FIG. 2 corresponds to a cross-sectional view taken along line I-I in FIG. 1.

As illustrated in FIGS. 1 and 2, a laminated structure 1 according to the first embodiment includes a cold plate 10, a printed circuit board 20, a semiconductor chip 30, and a bonding material 40.

The cold plate 10 has an upper surface 10A and a lower surface 10B. For example, the cold plate 10 is made of metal. The cold plate 10 is an example of a cooling member.

The printed circuit board 20 is provided on the cold plate 10. The printed circuit board 20 has an upper surface 20A and a lower surface 20B. The printed circuit board 20 has a base 21 and a metal pad 22. The base 21 has, for example, a wiring layer and an insulating layer. The metal pad 22 is connected to the wiring layer and is provided on the upper surface 20A of the printed circuit board 20. For example, the metal pad 22 has a gold layer or a copper layer on its surface. A through hole 25 is formed in the printed circuit board 20. The upper end of the through hole 25 is on the upper surface 20A and the lower end is on the lower surface 20B. The through hole 25 penetrates the metal pad 22. The aspect ratio (depth/diameter) of the through hole 25 is, for example, 1 or less. The printed circuit board 20 is an example of a circuit board.

The semiconductor chip 30 is provided on the printed circuit board 20. The semiconductor chip 30 includes a quantum bit. In plan view, the semiconductor chip 30 overlaps a through hole 25 formed in the printed circuit board 20. The semiconductor chip 30 has an upper surface 30A and a lower surface 30B. The semiconductor chip 30 has a rectangular planar shape with a side length of approximately 15 mm to 40 mm. The semiconductor chip 30 may have a square planar shape. The semiconductor chip 30 has a base 31, a metal pad 32, and an internal circuit 33. The base 31 includes, for example, silicon. The metal pad 32 is provided on the lower surface 30B of the semiconductor chip 30. For example, the metal pad 32 has a titanium layer and a gold layer covering the titanium layer. A nickel layer may be provided between the titanium layer and the gold layer. The internal circuit 33 is provided in the base 31. The internal circuit 33 constitutes a circuit for controlling a qubit included in a qubit substrate mounted on the semiconductor chip 30, the circuit being an inductor and an antenna, for example. The internal circuit 33 includes, for example, a material that becomes a superconductor at a temperature at which the qubit operates, for example, at a temperature of approximately -270°C. The semiconductor chip 30 is an example of a device (die), and a transistor or an interlayer connection via may be provided on the semiconductor chip 30.

The bonding material 40 bonds the printed circuit board 20 and the semiconductor chip 30 to each other. The bonding material 40 has a first bonding portion 41 and a second bonding portion 42. The first bonding portion 41 and the second bonding portion 42 are in contact with each other in a direction perpendicular to the laminating direction of the printed circuit board 20 and the semiconductor chip 30. The thermal conductivity of the first bonding portion 41 is higher than that of the second bonding portion 42, and the elastic modulus of the second bonding portion 42 is lower than that of the first bonding portion 41.

The first bonding portion 41 is in contact with at least a portion of the upper surface 10A of the cold plate 10 exposed from the through hole 25, the upper surface 20A of the printed circuit board 20, and the lower surface 30B of the semiconductor chip 30. The through hole 25 is filled by a first bonding portion 41. The first bonding portion 41 has a base 50, a first intermetallic compound layer 51, a second intermetallic compound layer 52, and a third intermetallic compound layer 53. The base 50 occupies most of the first bonding portion 41.

The base 50 contains a metal. The base 50 is a wiring containing, for example, indium, tin, lead, silver, copper, bismuth, aluminum, or any combination thereof. For example, the thermal conductivity of the base 50 is 100 W/m·K or higher.

The first intermetallic compound layer 51 is in contact with the upper surface 10A of the cold plate 10. The first intermetallic compound layer 51 is provided between the base 50 and the cold plate 10. For example, the first intermetallic compound layer 51 includes an intermetallic compound between a metal contained in the base 50 and a metal contained in the cold plate 10. The first intermetallic compound layer 51 includes, for example, an In-Au intermetallic compound, an In-Sn intermetallic compound, an Ag-Sn intermetallic compound, a Bi-In intermetallic compound, a Sn-Cu intermetallic compound, a Ni-Cu intermetallic compound, a Ni-Al intermetallic compound, a Ni-Sn intermetallic compound, or an Au-Sn intermetallic compound.

The second intermetallic compound layer 52 is in contact with the lower surface 30B of the semiconductor chip 30. More specifically, the second intermetallic compound layer 52 is in contact with the metal pad 32 of the semiconductor chip 30. The second intermetallic compound layer 52 is provided between the base 50 and the metal pad 32. For example, the second intermetallic compound layer 52 includes an intermetallic compound of a metal contained in the base 50 and a metal contained in the metal pad 32. The second intermetallic compound layer 52 includes, for example, an In-Au intermetallic compound, an In-Sn intermetallic compound, an Ag-Sn intermetallic compound, a Bi-In intermetallic compound, a Sn-Cu intermetallic compound, a Ni-Cu intermetallic compound, a Ni-Al intermetallic compound, a Ni-Sn intermetallic compound, or an Au-Sn intermetallic compound.

The third intermetallic compound layer 53 is in contact with the upper surface 20A of the printed circuit board 20. More specifically, the third intermetallic compound layer 53 is in contact with the metal pad 22 of the printed circuit board 20. The third intermetallic compound layer 53 is provided between the base 50 and the metal pad 22. For example, the third intermetallic compound layer 53 includes an intermetallic compound of a metal contained in the base 50 and a metal contained in the metal pad 22. The third intermetallic compound layer 53 includes, for example, an In-Au intermetallic compound, an In-Sn intermetallic compound, an Ag-Sn intermetallic compound, a Bi-In intermetallic compound, a Sn-Cu intermetallic compound, a Ni-Cu intermetallic compound, a Ni-Al intermetallic compound, a Ni-Sn intermetallic compound, or an Au-Sn intermetallic compound.

The second bonding portion 42 is provided around the first bonding portion 41 in plan view. The second bonding portion 42 contacts at least the upper surface 20A of the printed circuit board 20 and the lower surface 30B of the semiconductor chip 30. The second bonding portion 42 contains a resin. The second bonding portion 42 partially contains, for example, epoxy, polyethylene terephthalate (PET), polyether ether ketone (PEEK), polypropylene (PP), polyimide, or any combination thereof. For example, the elastic modulus of the second bonding portion 42 is 1 GPa or less.

In plan view, the outer edge of the first bonding portion 41 becomes smaller the further away from the lower surface 30B of the semiconductor chip 30 the outer edge is, that is, the outer edge becomes smaller the closer to the upper surface 20A of the printed circuit board 20 the outer edge is. Therefore, in plan view, the outer edge 41A of the surface of the first bonding portion 41 in contact with the lower surface 30B of the semiconductor chip 30, is outside the outer edge 41B of the surface of the first bonding portion 41 in contact with the upper surface 20A of the printed circuit board 20. In FIG. 2, the side surface of the first bonding portion 41 is schematically a flat inclined surface, but the side surface of the first bonding portion 41 may be uneven.

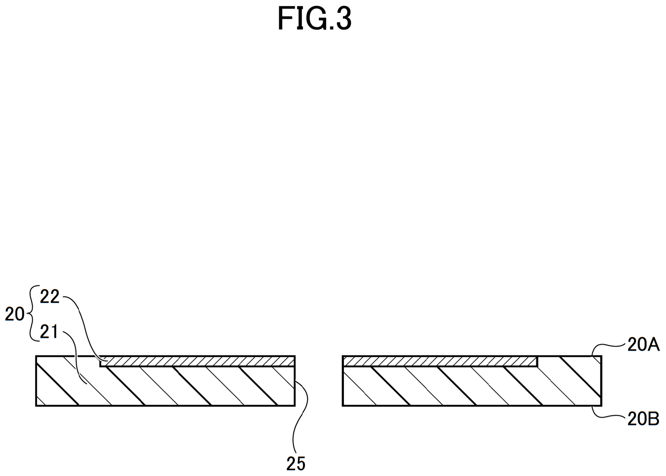

Next, a method of manufacturing the laminated structure 1 according to the first embodiment will be described. FIGS. 3 to 8 are cross-sectional views illustrating a method of manufacturing the laminated structure 1 according to the first embodiment.

First, as illustrated in FIG. 3, a printed circuit board 20 having a base 21 and a metal pad 22 is prepared, and a through hole 25 is formed in the printed circuit board 20. The through hole 25 can be formed by, for example, drilling, laser processing, sandblasting, or the like.

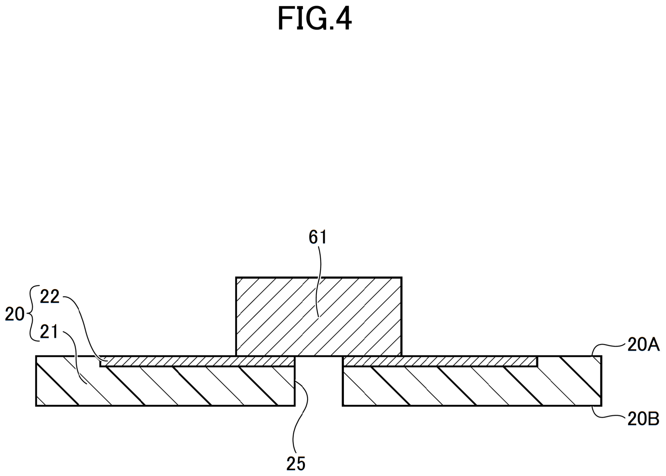

Next, as illustrated in FIG. 4, a first die bonding agent 61, which is a bonding member containing a metal, is provided on a portion of the metal pad 22 so as to cover the through hole 25. The first die bonding agent 61 can be applied by using, for example, a dispenser. The first die bonding agent 61 may be applied by squeegee printing. The first die bonding agent 61 contains, for example, indium, tin, lead, silver, copper, bismuth, aluminum, or any combination thereof. The first die bonding agent 61 is provided with a thickness of, for example, 30 µm or more. The first die bonding agent 61 is an example of a first bonding member.

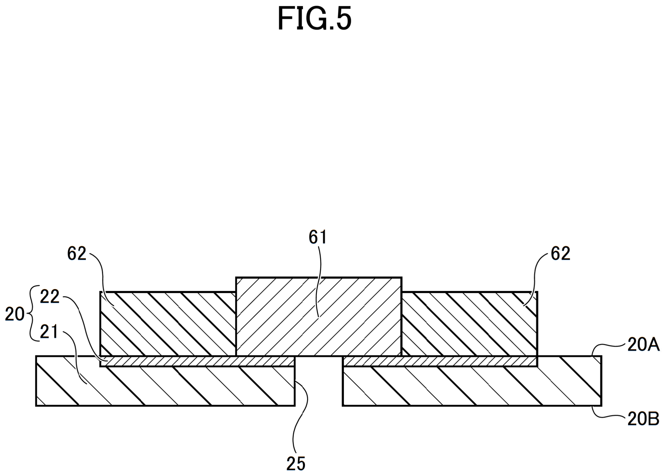

Thereafter, as illustrated in FIG. 5, a second die bonding agent 62 containing a thermosetting resin is provided on a portion of the metal pad 22 where the first die bonding agent 61 is not applied. The second die bonding agent 62 is provided around the first die bonding agent 61 in plan view. The second die bonding agent 62 can be applied, for example, by using a dispenser. The second die bonding agent 62 may be provided by applying a film. The second die bonding agent 62 contains, for example, epoxy, PET, PEEK, polyimide, or any combination thereof. The second die bonding agent 62 is provided to be thinner than the first die bonding agent 61. The second die bonding agent 62 is applied with a thickness of, for example, approximately 10 µm to 20 µm. The second die bonding agent 62 is an example of a second bonding member.

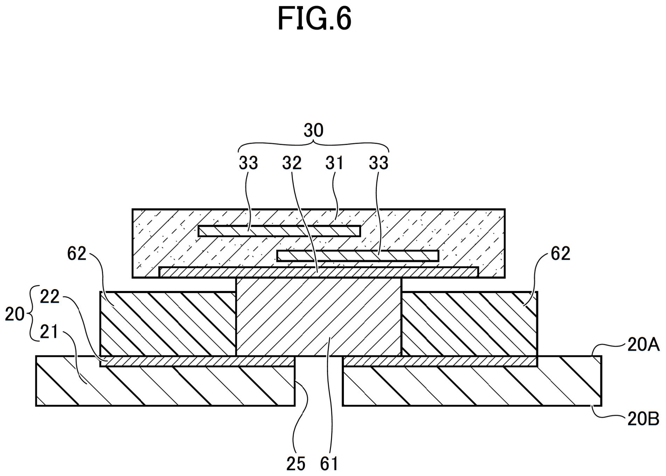

Subsequently, as illustrated in FIG. 6, the semiconductor chip 30 is placed on the first die bonding agent 61. At this time, the metal pad 32 is brought into contact with the first die bonding agent 61.

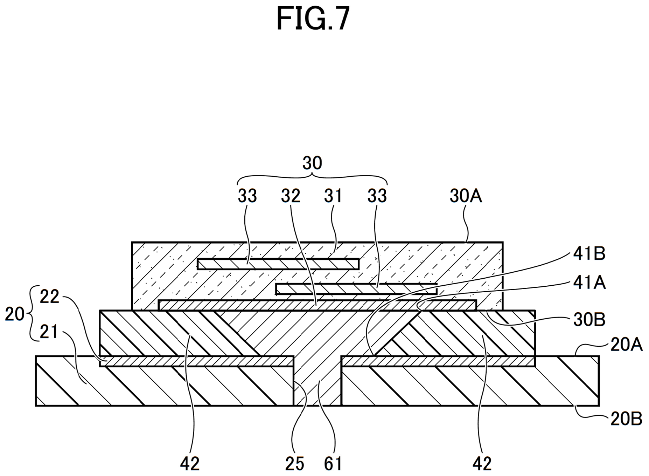

Next, the structure illustrated in FIG. 6 is heated to a temperature at which the first die bonding agent 61 melts or softens and the thermosetting resin contained in the second die bonding agent 62 hardens. As a result, as illustrated in FIG. 7, the first die bonding agent 61 flows into the through hole 25, the semiconductor chip 30 comes into contact with the second die bonding agent 62, and the second die bonding agent 62 thermally hardens to form the second bonding portion 42. That is, the printed circuit board 20 and the semiconductor chip 30 are bonded by the second bonding portion 42. In plan view, the outer edge 41A of the surface of the first die bonding agent 61 in contact with the lower surface 30B of the semiconductor chip 30 is located outside the outer edge 41B of the surface of the first die bonding agent 61 in contact with the upper surface 20A of the printed circuit board 20. For example, when the metal contained in the first die bonding agent 61 is silver and the thermosetting resin contained in the second die bonding agent 62 is epoxy, the heating temperature is approximately 100°C. For example, when the metal contained in the first die bonding agent 61 is indium and the thermosetting resin contained in the second die bonding agent 62 is epoxy, the heating temperature is approximately 120 °C.

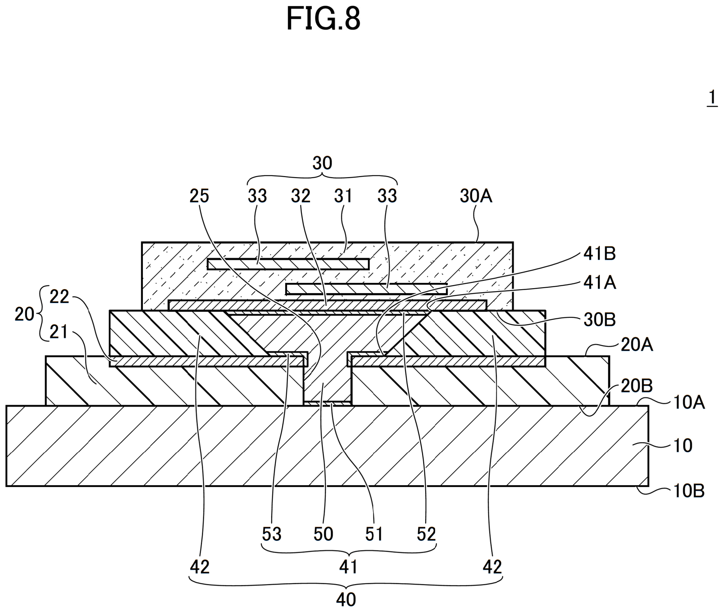

Then, as illustrated in FIG. 8, the structure illustrated in FIG. 7 is fixed to the cold plate 10, heated to a temperature at which the first die bonding agent 61 melts, held for approximately 10 seconds, and cooled. As a result, the first bonding portion 41 is formed from the first die bonding agent 61, and the printed circuit board 20, the semiconductor chip 30, and the cold plate 10 are bonded by the first bonding portion 41. At this time, the first intermetallic compound layer 51, the second intermetallic compound layer 52, and the third intermetallic compound layer 53 are formed.

In this manner, the laminated structure 1 according to the first embodiment can be manufactured.

In the laminated structure 1, heat generated in the semiconductor chip 30 is mainly transmitted to the cold plate 10 through the first bonding portion 41 and discharged from the cold plate 10 to the outside. Therefore, thermal conductivity can be improved. Further, even when the difference in the thermal expansion coefficient between the first bonding portion 41 and the printed circuit board 20 is large, the second bonding portion 42 is provided around the first bonding portion 41 in plan view, and, therefore, thermal stress caused by the difference in the thermal expansion coefficient can be mitigated. As described above, according to the first embodiment, both improvement in thermal conductivity and mitigation of thermal stress can be achieved.

In particular, the outer edge 41A of the surface of the first bonding portion 41 in contact with the lower surface 30B of the semiconductor chip 30 is located outside the outer edge 41B of the surface of the first bonding portion 41 in contact with the upper surface 20A of the printed circuit board 20 in plan view, and, therefore, the first bonding portion 41 can easily absorb heat from the semiconductor chip 30, and the second bonding portion 42 can easily mitigate thermal stress. The angle formed by a straight line passing through a first point on the outer edge 41A and a second point on the outer edge 41B closest to the first point, and the lower surface 30B of the semiconductor chip 30, is preferably greater than or equal to 20° and less than or equal to 80°, more preferably greater than or equal to 30° and less than or equal to 70°, and more preferably greater than or equal to 40° and less than or equal to 60°. When this angle is excessively large or excessively small, there is a possibility that improvement of thermal conductivity and mitigation of thermal stress are difficult to achieve at the same time.

Further, because indium becomes a superconductor at a very low temperature, when the metal contained in the first bonding portion 41 is indium, it is suitable for improvement of stability of operation of the qubit.

Further, because the first intermetallic compound layer 51 is formed, excellent adhesion is obtained between the first bonding portion 41 and the cold plate 10, and good thermal conductivity is obtained. Further, because the second intermetallic compound layer 52 is formed, excellent adhesion is obtained between the first bonding portion 41 and the semiconductor chip 30, and good thermal conductivity is obtained. Furthermore, because the third intermetallic compound layer 53 is formed, excellent adhesion is obtained between the first bonding portion 41 and the printed circuit board 20. However, the first intermetallic compound layer 51, the second intermetallic compound layer 52, and the third intermetallic compound layer 53 need not be formed.

Further, when the thickness of the second die bonding agent 62 is 10 µm to 20 um, bubbles do not easily enter the bonding material 40, and thermal stress is easily mitigated.

A metal layer containing gold, tin, bismuth, copper, silver or any combination thereof may be formed on the inner wall surface of the through hole 25. In this case, the wettability and adhesion of the first die bonding agent 61 can be improved.

A plurality of through holes 25 may be formed in the printed circuit board 20.

### (Second embodiment)

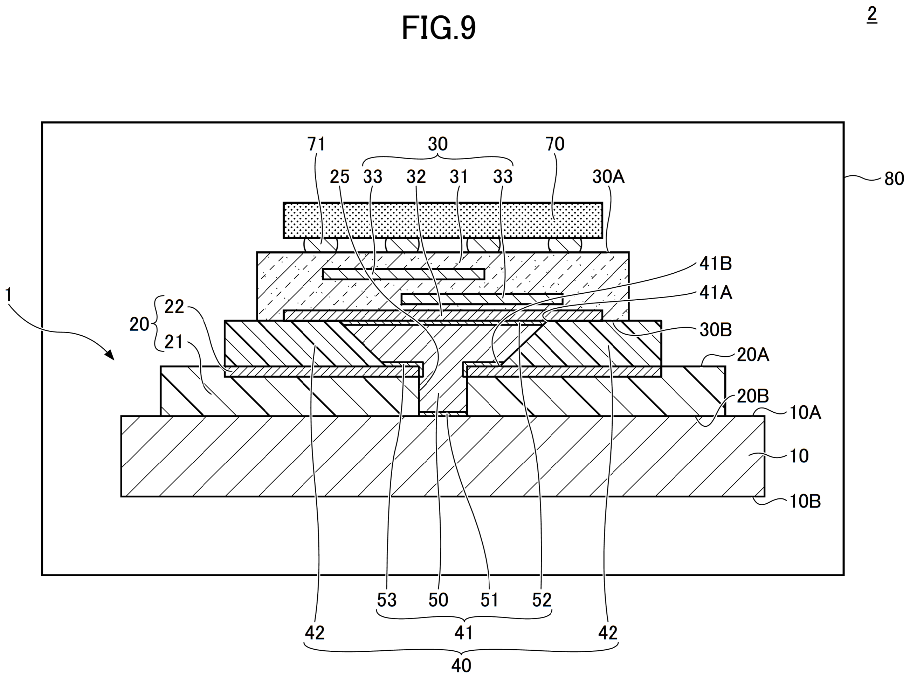

Next, a second embodiment will be described. The second embodiment relates to a quantum device including the laminated structure 1 according to the first embodiment. FIG. 9 is a cross-sectional view illustrating a quantum device according to the second embodiment.

As illustrated in FIG. 9, a quantum device 2 according to a second embodiment includes a laminated structure 1, a quantum bit substrate 70, and a refrigerator 80. The quantum bit substrate 70 includes a quantum bit. The quantum bit is, for example, a color center in a diamond. The quantum bit substrate 70 is flip-chip mounted on a semiconductor chip 30 of the laminated structure 1 through a conductive bonding material 71. The laminated structure 1 and the quantum bit substrate 70 are housed in the refrigerator 80. The refrigerator 80 cools the laminated structure 1 and the quantum bit substrate 70 to a very low temperature of approximately -270°C.

In the quantum device 2, heat generated in the semiconductor chip 30 is transferred to the cold plate 10 with high efficiency and is discharged into the refrigerator 80.

The laminated structure and the quantum device according to the present disclosure can be used, for example, in quantum computing.

Although the preferred embodiments and the like have been described in detail, the embodiments and the like described above are not limited, and various modifications and substitutions can be made to the embodiments and the like described above without departing from the scope of the claims.

### REFERENCE SIGNS LIST

1: laminated structure
2: quantum device
10: cold plate
20: printed circuit board
22: metal pad
25: through hole
30: semiconductor chip
32: metal pad
40: bonding material
41: first bonding portion
41A, 41B: outer edge
42: second bonding portion
50: base
51: first intermetallic compound layer
52: second intermetallic compound layer
53: third intermetallic compound layer
61: first die bonding agent
62: second die bonding agent
70: quantum bit substrate
80: refrigerator

## Claims

1. A laminated structure comprising:
a cooling member;
a circuit board provided on the cooling member and formed with a through hole;
a device provided on the circuit board and including a quantum bit; and
a bonding material configured to bond the circuit board and the device to each other, wherein
the bonding material includes:
a first bonding portion in contact with a portion of an upper surface of the cooling member exposed from the through hole, an upper surface of the circuit board, and a lower surface of the device; and
a second bonding portion provided around the first bonding portion in plan view and in contact with at least the upper surface of the circuit board and the lower surface of the device, and wherein
a thermal conductivity of the first bonding portion is higher than a thermal conductivity of the second bonding portion, and
an elastic modulus of the second bonding portion is lower than an elastic modulus of the first bonding portion.

2. The laminated structure according to claim 1, wherein, in plan view, an outer edge of a surface of the first bonding portion in contact with the lower surface of the device is outside an outer edge of a surface of the first bonding portion in contact with the upper surface of the circuit board.

3. The laminated structure according to claim 1 or 2, wherein the first bonding portion includes a metal.

4. The laminated structure according to claim 3, wherein the metal is indium.

5. The laminated structure according to claim 3, wherein the first bonding portion includes a first intermetallic compound layer in contact with the upper surface of the cooling member.

6. The laminated structure according to claim 3, wherein the first bonding portion includes a second intermetallic compound layer in contact with the lower surface of the device.

7. The laminated structure according to claim 3, wherein the first bonding portion includes a third intermetallic compound layer in contact with the upper surface of the circuit board.

8. The laminated structure according to claim 1 or 2, wherein the second bonding portion includes a resin.

9. The laminated structure according to claim 1 or 2, wherein the device has a circuit including a material serving as a superconductor.

10. A quantum device comprising:
the laminated structure according to claim 1 or 2; and
a quantum bit substrate mounted on the device.

11. A method of manufacturing a laminated structure, the method comprising:
forming a through hole in a circuit board;
providing a first bonding member on the circuit board so as to cover the through hole;
providing a second bonding member around the first bonding member on the circuit board;
causing the first bonding member to flow into the through hole while bonding a device including a quantum bit and the circuit board to each other by the second bonding member; and
fixing the circuit board to a cooling member and bonding the device and the cooling member to each other by the first bonding member flowing into the through hole, wherein
a thermal conductivity of a first bonding portion formed from the first bonding member is higher than a thermal conductivity of a second bonding portion formed from the second bonding member; and
an elastic modulus of the second bonding portion is lower than the elastic modulus of the first bonding portion.

12. The method of manufacturing the laminated structure according to claim 11, wherein
the first bonding member includes a metal, and
the second bonding member includes a thermosetting resin.
